# EUROPEAN PATENT APPLICATION

(11) **EP 3 544 172 A1**
(43) Date of publication of application: **25.09.2019**
(21) Application number: 18163706.7
(22) Date of filing: 23.03.2018
(51) Int. Cl.: H02N 2/18, H01L 41/113, E04F 15/02

(54) **PIEZOELECTRIC ENERGY HARVESTING SYSTEM**

(71) Applicant: Nederlandse Organisatie voor toegepast- natuurwetenschappelijk onderzoek TNO, 2595 DA 's-Gravenhage (NL)
(72) Inventor: Groen, Wilhelm Albert, 2595 DA 's-Gravenhage (NL); Smits, Edsger Constant Pieter, 2595 DA 's-Gravenhage (NL)
(74) Representative: V.O.

(57) **Abstract**

A bendable metal plate (12) is connected to a piezo-electric plate (11) for applying compressive forces. A pocket (H1) is formed at a central part (12c) of the metal plate (12) opposite the piezo-electric plate (11). A force receiving surface (31) moves under influence of an external force, applied to the force receiving surface (31) while a pressure centralizing element (33) is configured to focus a central force exclusively to a center (11c) of the piezo-electric plate (11). The metal plate (12) thus bends to a compressive bending position under the influence of the external force by a combination of the central force on the center (11c) of the piezo-electric plate (11) and edge forces by the pocket structure (13) on the outer edges (12e) of the metal plate (12).

## Description

### TECHNICAL FIELD AND BACKGROUND

The present disclosure relates to a piezo-electric energy harvesting system, and corresponding use.

Energy harvesting systems may be used to generate electricity e.g. from varying pressure, force, or vibrations. For example, US 2017/0143308A1 by Yamasaki et al. describes various configurations with a piezo-electric element, some of which may be suitable as an energy harvester. The known piezo-electric element comprises a piezo-electric body and a vibrating silicon plate. A support substrate is bonded to the vibrating plate and includes a hollow portion at a position overlapped with the piezo-electric body in a plan view in a thickness direction of the support substrate.

Unfortunately, known energy harvesting systems may suffer from failure under some circumstances of use. Popular piezo-electric materials such as piezo-ceramics (or single crystal material), can be brittle and vulnerable in particular to tensile stress. For example, the compressive strength of PZT (>517 MPa) is much higher than its tensile strength (∼75.8 MPa). In some cases a polymer piezo-electric material (e.g. based on PVDF or its copolymers) can be used, but this may have relatively low energy output.

So here remains a need for an improved design energy harvesting system, particularly with regards to optimizing energy output while alleviating damage.

### SUMMARY

Some aspect of the present disclosure may provide an energy harvesting system where external forces are focused to optimal positions while tensile stresses to the piezo-electric material are avoided.

In a system, as described herein, a piezo-electric plate, preferably ceramic, is configured to output electrical energy to an electrical circuit. This may happen under influence of compressive forces changing the piezo-electric plate between an uncompressed state and a compressed state. A bendable metal plate can be connected, e.g. glued, to the piezo-electric plate for applying the compressive forces on the piezo-electric plate. This may happen e.g. when bending the metal plate from an unbent position to a compressive bending position, i.e. with outer edges of the metal plate bending towards and partially around the piezo-electric plate.

Preferably, as described herein, a pocket structure may form a pocket which can be located at a central part of the metal plate, i.e. on an opposite side of the metal plate with respect to the piezo-electric plate. This may allow the bending of the metal plate at least partly into the pocket in the compressive bending position. The pocket structure may thus be configured to abut the metal plate exclusively at its outer edges and not at the center. When the center is pushed into the pocket, this may result in (reaction) edge forces of the abutting pocket structure on the metal plate directed generally towards side of the piezo-electric plate. A force receiving surface may be configured to move under influence of an external force, applied to the force receiving surface. The surface may move from an equilibrium surface position to a compressed surface position, i.e. closer towards the pocket structure.

More preferably, as described herein, a pressure centralizing element may be located centrally with respect to the piezo-electric plate between the force receiving surface and the piezo-electric plate. The element may thus be configured to focus a central force exclusively to a center of the piezo-electric plate (and not at the edges of the plate). The central force may be generally directed towards the piezo-electric plate upon application of the external force moving the force receiving surface to the compressed surface position.

Accordingly, the metal plate may bend to the compressive bending position under the influence of the external force by a combination of the central force on the center of the piezo-electric plate and the edge forces, oppositely directed to the central force, on the outer edges of the metal plate. It will be appreciated that the configuration may be used to efficiently bend the piezo-electric device while avoiding tensile stress. In a preferred embodiment, two piezo-electric devices may be applied back to back with the pressure centralizing element between the respective piezo-electric plates. In this way the power output may be effectively increased even further while maintaining alleviation of tensile stress. Furthermore, because the combined piezo elements may move together, they can be connected as one, e.g. with a single rectifier circuit.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A and 1B illustrate a schematic cross-section of a first embodiment for an energy harvesting system in different states;
FIGs 2A and 2B illustrate a schematic cross-section of a second embodiment for an energy harvesting system in different states;
FIG 3A illustrates a schematic connection of a piezo-electric device to an electrical circuit;
FIG 3B illustrates an array of multiple piezo-electric devices to power an electrical device;
FIG 4A illustrates a photograph of an embodiment of an energy harvesting system with piezo-electric devices;
FIG 4B illustrates a graph of measured energy.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

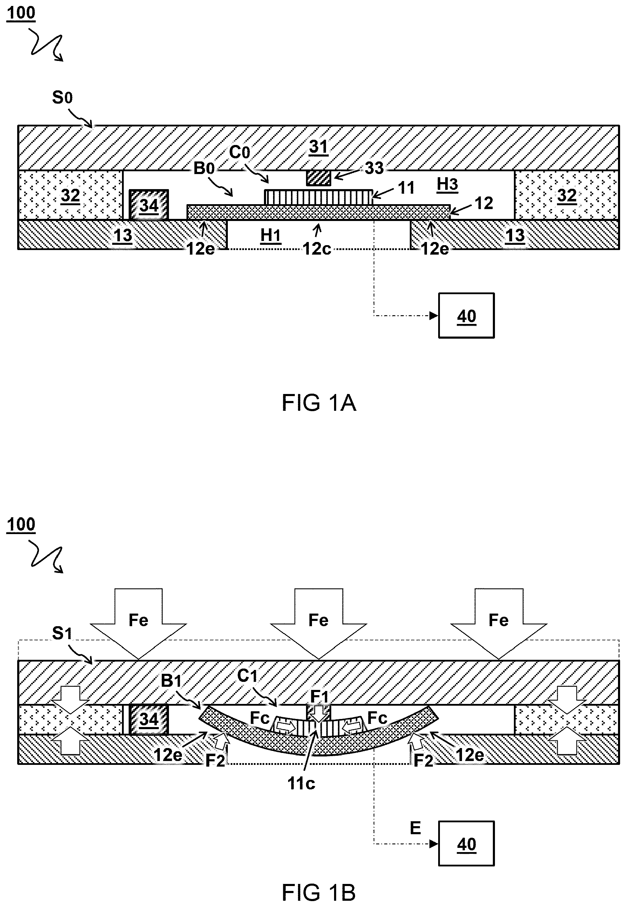

FIGs 1A and 1B illustrate a schematic cross-section of a first embodiment for an energy harvesting system 100 in equilibrium and compressed states, respectively.

In one embodiment, as shown, a first piezo-electric plate 11 is configured to output electrical energy (schematically indicated by "E") to an electrical circuit 40. The energy may be generated e.g. under influence of compressive forces "Fc". Such forces may change the first piezo-electric plate 11 between an uncompressed state "C0", as shown in FIG 1A, and a compressed state "C1", as shown in FIG 1B. Alternatively, or in addition, energy may also be generated when the system relaxes back from the compressed state "C1" to the uncompressed state "C0"

In another or further embodiment, as shown, a bendable first metal plate 12 is connected to the first piezo-electric plate 11. For example, the plates are connected along their overlapping surfaces, e.g. glued. In this way a compressive forces "Fc" may be applied on the first piezo-electric plate 11 when bending the first metal plate 12. In this case, from an unbent position "B0", as shown in FIG 1A, to a compressive bending position "B1", as shown in FIG 1B. In the compressive bending position "B1", outer edges 12e of the first metal plate 12 may be bent towards and/or partially around the first piezo-electric plate 11, as shown.

In a preferred embodiment, as shown, a first pocket structure 13 is provided to form a first pocket "H1" disposed at a central part 12c of the first metal plate 12 . The first pocket structure 13 is disposed on an opposite side of the first metal plate 12 with respect to the first piezo-electric plate 11. In this way the pocket may allow bending of the first metal plate 12 at least partly into the first pocket "H1" in the compressive bending position "B1", as shown in FIG 1B. Most preferably, the first pocket structure 13 is configured to abut the first metal plate 12 exclusively at its outer edges 12e. This may provide edge forces "F2" of the abutting first pocket structure 13 on the first metal plate 12 directed towards the first piezo-electric plate 11.

In some embodiments, as shown, a force receiving surface 31 is provided and configured to move under influence of an external force "Fe", e.g. applied to the force receiving surface 31, as shown in FIG 1B. This may result in moving the surface from an equilibrium surface position "S0" to a compressed surface position "S1", which may be closer towards the first pocket structure 13. Of course the reciprocal situation may also occur wherein the force is applied to the back. In any case, the outer surfaces of the stack may be squeezed together upon application of external force on one or both of the externals surfaces of the system.

In a preferred embodiment, as shown, a force or pressure centralizing element 33 is provided. In some embodiments, the pressure centralizing element 33 can be disposed at or near a center of a surface of the first piezo-electric plate 11, e.g. between the force receiving surface 31 (or intermediate surface, not shown here) and the first piezo-electric plate 11. The pressure centralizing element 33 can be configured to focus a central force F1 exclusively to a center 11c (and not the rim) of the first piezo-electric plate 11, e.g. upon application of the external force "Fe" moving the force receiving surface 31 to the compressed surface position "S1". Most preferably, the force F1 may be directed exclusively towards the first piezo-electric plate 11 (not pulling on the plate in the opposite direction).

So, preferably the first metal plate 12 is configured to bend to the compressive bending position "B1" under the influence of the external force "Fe" by a combination of the central force F1 on the center 11c of the first piezo-electric plate 11 and the edge forces "F2", oppositely directed to the central force F1, on the outer edges 12e of the first metal plate 12.

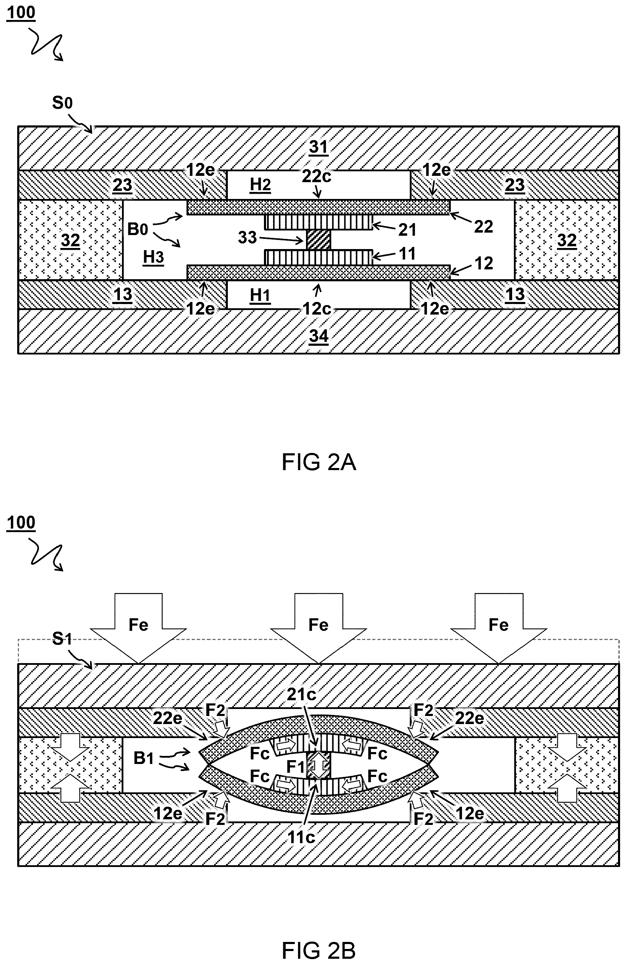

FIGs 2A and 2B illustrate a schematic cross-section of a second embodiment for an energy harvesting system 100 in in equilibrium and compressed states, respectively.

In a preferred embodiment, as shown, a system 100 similar as described with reference to FIG 1 may be provided, but comprising a second piezo-electric plate 21 and a (bendable) second metal plate 22 connected to the second piezo-electric plate 21. These plates 21,22 may be the same or similar as the first piezo-electric plate 11 and first metal plate 12. Both may be configured for applying compressive forces "Fc" on the respective piezo-electric plate when the respective metal plate is bent and outputting electrical energy to the (same) electrical circuit (not shown here).

In another or further preferred embodiment, as shown, a second pocket structure 23 may be provided to form a second pocket "H2". The second pocket may be located at a central part 22c of the second metal plate 22 opposite the second piezo-electric plate 21 for allowing the bending of the second metal plate 22 at least partly into the second pocket "H2". Also, the second pocket structure 23 can be configured to abut the second metal plate 22 exclusively at its outer edges 22e with edge forces "F2" directed towards the second piezo-electric plate 21 (generally opposite to the edge forces on the first metal plate 12).

In a most preferably embodiment, as shown, the pressure centralizing element 33 is disposed centrally between the piezo-electric plates 11,21. So it can be configured to focus the central force F1 on either side (in opposite directions), preferably exclusively to the respective centers 11c,21c of the piezo-electric plates 11,21 upon application of the external force "Fe" moving the force receiving surface 31 to the compressed surface position "S1", or vice versa.

Typically, as shown in FIGs 1 and 2, a diameter of the first and optional second piezo-electric plate 11,21 (measured along the plate surface) is larger than a diameter of the pressure centralizing element 33, e.g. by a factor two, three, four or more. In other words, the pressure centralizing element 33 is preferably configured to only contact (or engage) with a part of the surface of the respective piezo-electric plate, preferably at or near a center of the plate. The smaller the relative size of the pressure centralizing element 33 with respect to the respective piezo-electric plate, the more focused the applied central force F1 which may improve bending action in combination with the edge forces "F2".

In some embodiments, e.g. according to FIG 1, the system may comprise a resilient element 32 between the force receiving surface 31 and the first pocket structure 13. The resilient element 32 may help to restore the force receiving surface 31 from the compressed surface position "S1" to the equilibrium surface position "S0", e.g. in the absence of external force "Fe". Also in the embodiments of FIG 2, the resilient element 32 is between the force receiving surface 31 and the first pocket structure 13, more specifically between the first pocket structure 13 and the second pocket structure 23.

In a preferred embodiment, the resilient element 32 comprises a compressible side wall foam layer which (in plane) surrounds the stack of the piezo-electric device, i.e. the first and/or second piezo-electric plate 11,21, the first and/or second metal plate 12,22, and the pressure centralizing element 33. So the side wall foam layer may act in parallel with the bending plates upon application of external force. A foam may be relatively easy to compress for a certain range while providing more resistance beyond a threshold, which may be advantageous here to protect the plates against excessive pressure. Alternatively, or additionally, also other resilient elements or materials such as rubbers can be envisioned, e.g. having a compressibility (and restoration) of at least ten percent, twenty percent, thirty percent or more, e.g. up to fifty percent or sixty percent.

Alternatively, or additionally to a dedicated resilient element, the metal plate(s) and/or piezo-electric plate(s) may also act themselves as a resilient element with a resilient force to restore them to the unbent position and uncompressed state, respectively. Optionally, as shown in FIG 1, the system may comprise a spacer 34, e.g. between the force receiving surface 31 and the first pocket structure 13, for maintaining a minimum distance, e.g. setting a maximum bending of the metal plate and thereby a maximum compression of the piezo-electric plate. A similar spacer can also be applied e.g. between the pocket structures of FIG 2 (not shown). Alternatively, or additionally to a dedicated spacer, the minimum distance may be set by a maximum compression of the resilient element 32. Alternatively, or additionally, a maximum bending of the metal plate may also be determined by the edges and/or central part of the metal plate meeting another surface, e.g. the edges abutting a bottom of the force receiving surface, as shown, or the central part abutting a bottom of the pocket (not shown). In particular for the embodiment of FIG 2, the maximum bending may also be determined by a thickness of the piezo-electric plates 11,21 and the pressure centralizing element 33 determining how far the metal plates 12,22 can bend before meeting. So a thickness of the pressure centralizing element 33 can be advantageously used to tune a maximum bending of the metal plates.

Preferably, the pockets H1 and/or H2 are air pockets, providing minimal resistance to bending of the metal plates 12 and/or 22. Similarly, an air pocket H3 may also be formed at the other side of the metal plates to allow the bending. Alternatively to an air pocket, a highly resilient material may optionally be used to fill one or more of the pockets H1,H2,H3, e.g. providing minimal resistance while ensuring the maintained position of the elements. Any (solid) material optionally filling the pockets, preferably has a much lower stiffness than the respective pocket structures, e.g. with a lower Young's modulus by at least a factor two, three, five, ten, or more.

Preferably, the respective pocket structures 13,23 comprise a relatively rigid or incompressible material so the pocket structure may press against the edges of the respective metal plate 12,22 to bend the plate. For example, the stiffness or Young's modulus of the pocket structure's material is higher than a stiffness of the resilient element's material and/or higher than the corresponding stiffness (e.g. in force per unit displacement) of the combined metal and ceramic plate(s). For example, the pocket structure material has a Young's modulus of more than one or two Giga Pascal. The pockets may typically have a respective depth more than a thickness of the respective metal plate, preferably more than a combined thickness of the respective metal plate and piezo-electric plate. In one embodiment, the first and optional second pocket structure 13,23 comprise a foil with a hole centralized with respect to a position of the metal plate. For example, a PET (or PEN) foil can be used with a typical Young's modulus between 2-2.7 GPa.

In a preferred embodiment, e.g. as shown in FIGs 1 and 2, a diameter of the first and optional second metal plate 12,22 (measured along the plate surface) is larger than a diameter of the first and optional second pocket "H1",H2, respectively. For example, the respective metal plate 12 or 22 may have some overlap with the edges of the respective pocket structure H1 or H2. In this way the respective pocket structure 13 or 23 may act to provide the edge forces along an entire rim of the respective metal plate 12 or 22. For example, the (minimum) diameter of the respective metal plate may be larger than the (maximum) diameter of the respective pocket by at least a factor 1.1, preferably at least 1.2 or 1.3. Having a minimum overlap may ensure that the edges of the metal plate do not fall in the pocket as the plate is bent. In some embodiments, the edges of at least one of the metal plate may be attached, e.g. glued, to the respective pocket structure to ensure its position. Alternatively, or additionally, the metal plates may be kept in place by a lateral constricting structure (not shown).

In a preferred embodiment, a diameter of the first and optional second metal plate 12,22 is larger than a diameter of the first and optional second piezo-electric plate 11,21, respectively. For example, the diameter of the respective metal plate is larger by more than ten percent, or a factor 1.1, more than a factor 1.5, more than a factor two, as shown, or even more. The larger the diameter of the metal plate with respect to the piezo-electric plate, the easier it may be to bend the metal plate, e.g. acting similar to a longer lever to compress the piezo-electric plate.

In a preferred embodiment, a diameter of the first and optional second piezo-electric plate 11,12 is smaller than a diameter of the first and optional second pocket "H1",H2, respectively. For example, the (maximum) diameter of the piezo-electric plate is smaller than the (minimum) diameter of the respective pocket, by more than a factor 1.1, preferably at least 1.2 or 1.3. In this way, the piezo-electric plate may partly sink into the respective pocket, as shown. while the edges of the metal plate bend around it.

In some embodiments, the first and optional second piezo-electric plate 11,21 are piezoceramic plates. For example, lead zirconate titanate, commonly known as PZT, is a ceramic (perovskite) material. It will be appreciated that the present teachings are particularly suitable for piezoceramic (or single crystal) material in that the construction facilitates compressive forces on the piezo material while avoiding tensile forces which may damage the material.

Preferably, one or more, most preferably all, of the pocket, metal plate, and/or piezo-electric plate have a circular diameter. Also the pressure centralizing element may be circular. The piezo-electric plate, or disc, is preferably glued (centrally) onto the metal plate, or disc. In some embodiments, the pressure centralizing element may also be glued to the piezo-electric plate.

In other or further embodiments the pressure centralizing element may be disconnected from the piezo-electric plate, e.g. as shown in FIG 1A. Such configuration may have an advantage of preventing any pulling forces (and tensile stress) on the piezo-electric plate. More generally, the pressure centralizing element 33 is preferably connected exclusively on one side, either to the force receiving surface (as shown), or to the first piezo-electric plate (not shown). Alternatively, or in addition, the metal plate may be partially or fully disconnected from the pocket structure so that it will be lifted instead of bent in the opposite direction. When using two piezo-electric devices, e.g. as shown in FIG 2A, it may be sufficient to disconnected at least one of the contact points in the stack between the first pocket structure 13 and the second pocket structure 23. For example, the pressure centralizing element 33 is connected to the first piezo-electric plate 11 but disconnected from the first metal plate 12, optionally while still in contact. Alternatively one of the first or second metal plates 12,22 is disconnected from the respective pocket structure 13,23.

Typically, the energy harvesting system 100 comprises a force receiving surface 31, e.g. preferably an addition (closed) surface which may cover the piezo-electric device and/or the second pocket structure 23. The force receiving surface may act e.g. as a protective coating. Also other layers may be added above or below the stack, as shown. In the embodiment of FIG 2, an optional additional (backside) layer 34 is added to the bottom of the structure. This can make the structure (mirror) symmetric about a plane through the pressure centralizing element 33. So the layer 34 may also act as an additional or alternative force receiving surface. Generally, the backside layer, either 13 or 34 may abut against another surface, e.g. the floor or wall. So it will be understood that while the force receiving surface 31 receives an external force "Fe", there may be an equal but opposite force acting from the abutting other surface, e.g. floor, to squeeze the one or more piezo-electric devices there between.

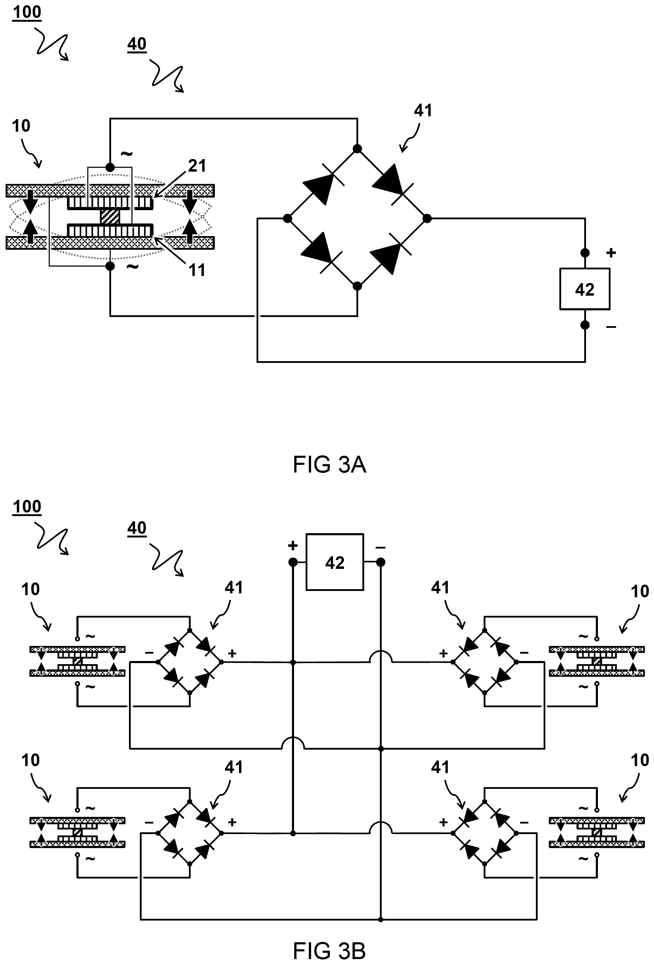

FIG 3A illustrates a schematic connection of a piezo-electric device 10 to an electrical circuit 40. For example, the piezo-electric device 10 may be similar as the embodiment of FIG 2 (pocket structures not shown here)

When using multiple piezo-electric plates, interference between them may be alleviated by placing a rectifier in front of each of them. For example, this may prevent transfer of energy from one of the piezo-electric plates, that has been actuated, to another that is in rest, or differently actuated. In some embodiments, the energy harvesting system 100 thus comprises a rectifier circuit 41 electrically connected to electrodes of the first and/or second piezo-electric plate 11,21. Typically, the rectifier circuit 41 is configured to convert an alternating current or voltage (∼) to a direct current or voltage (+/-). In some embodiments, the rectifier circuit 41 comprises one or more diodes, e.g. in a bridge as illustrated, to provide a full wave rectifier. Also alternative or additional electrical elements may be used to build a rectifier circuit.

In a preferred embodiment, the energy harvesting system 100 comprises one rectifier circuit 41 per pair of first and second piezo-electric plates 11,21. Most preferably, as shown, the top electrodes of the piezo-electric plates, opposite the respective metal plates are (directly electrically) connected to each other (e.g. by only electrical wire) as a first terminal connected to the rectifier circuit 41. Similarly, as also shown, the bottom electrodes of the piezo-electric plates at a side of the respective metal plates are connected to each other as a second terminal connected to the rectifier circuit 41 (parallel connection). Optionally, as shown, the bottom electrodes may be connected via the (conductive) metal plate. It will be appreciated that particularly for the design shown, the plates may bend simultaneously in the same direction, so the generated currents can be combined to the rectifier circuit with less risk that energy would flow from one plate to the other. Also there is no problem when the metal plates would contact each other when bending. Alternative to a parallel connection, in principle, also a serial connection may be possible (not shown), e.g. to increase voltage.

Optionally, the energy harvesting system 100 may be connected or integrated to power an electrical device 42, with or without the rectifier circuit 41 there between. For example, the electrical device 42 may comprise a transmitter configured to send a (wireless) signal when the energy harvesting system 100 is actuated. Alternatively, or in addition, the electrical device 42 may comprise an energy storage, e.g. battery, to store energy harvested by the system.

FIG 3B illustrates an array of multiple piezo-electric devices 10 to power an electrical device 42. In the embodiment shown, the rectifier circuits 41 are connected in parallel to power the load or electrical device 42. Alternatively, they can also be connected is series, e.g. to combine their voltages. Of course, while the figure shows only four piezo-electric devices 10, many more may be included to form an extended surface for energy harvesting such as a floor.

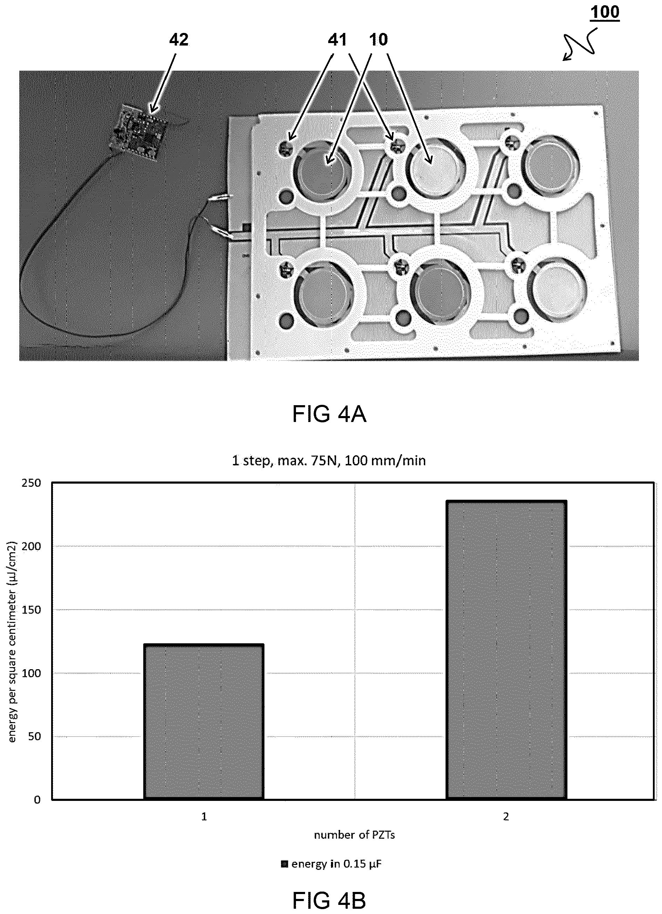

FIG 4A illustrates a photograph of an embodiment of an energy harvesting system 100 with piezo-electric devices 10, e.g. with similar layout as FIG 3B.

In a preferred embodiment, as shown, a respective combination of a piezo-electric plate and metal plate is formed by a piezo-electric buzzer. For example, a simple piezo-electric buzzer may be commercially available at low cost (e.g. 50-100 Eurocents). For example, a buzzer element may have a diameter between 5-50 mm. For example, a thin piezoceramic disc or plate of about 200 µm thickness may be glued on a metal plate usually a bit thinner, e.g. 100 µm. Of course also other dimensions are possible. One or more buzzers may be combined to form a respective piezo-electric device 10, as shown. The piezo-electric buzzer elements can be placed on a substrate with respective pockets and pressure centralizing elements and electrically connected to form an energy harvesting system.

FIG 4B illustrates a graph of measured energy for one or two PZTs used. For example, the system can be used to generate around a mJ of energy which may be sufficient to send a data package via a radio transmitter to provide information about the location of activities e.g. in a building. One application may e.g. be a floor mat comprising the energy harvesting system 100 as described herein, configured to power an electrical device, e.g. radio transmitter, when a person walks over the floor mat. Alternative applications may comprise e.g. integrating the energy harvesting system into a shoe (sole), article of clothing, or other wearable devices.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. An energy harvesting system (100) comprising
- a first piezo-electric plate (11) configured to output electrical energy (E) to an electrical circuit (40) under influence of compressive forces (Fc) changing the first piezo-electric plate (11) between an uncompressed state (C0) and a compressed state (C1);
- a bendable first metal plate (12) connected to the first piezo-electric plate (11) for applying the compressive forces (Fc) on the first piezo-electric plate (11) when bending the first metal plate (12) from an unbent position (B0) to a compressive bending position (B1) with outer edges (12e) of the first metal plate (12) bending towards and partially around the first piezo-electric plate (11);
- a first pocket structure (13) forming a first pocket (H1) disposed at a central part (12c) of the first metal plate (12) opposite the first piezo-electric plate (11) for allowing the bending of the first metal plate (12) at least partly into the first pocket (H1) in the compressive bending position (B1), wherein the first pocket structure (13) is configured to abut the first metal plate (12) exclusively at its outer edges (12e) with edge forces (F2) of the abutting first pocket structure (13) on the first metal plate (12) directed towards the first piezo-electric plate (11);
- a force receiving surface (31) configured to move under influence of an external force (Fe), applied to the force receiving surface (31), from an equilibrium surface position (S0) to a compressed surface position (S1) closer towards the first pocket structure (13); and
- a pressure centralizing element (33) disposed centrally with respect to the first piezo-electric plate (11) between the force receiving surface (31) and the first piezo-electric plate (11), and configured to focus a central force (F1) exclusively to a center (11c) of the first piezo-electric plate (11) towards the first piezo-electric plate (11) upon application of the external force (Fe) moving the force receiving surface (31) to the compressed surface position (S1);
- wherein the first metal plate (12) is configured to bend to the compressive bending position (B1) under the influence of the external force (Fe) by a combination of the central force (F1) on the center (11c) of the first piezo-electric plate (11) and the edge forces (F2), oppositely directed to the central force (F1), on the outer edges (12e) of the first metal plate (12).

2. The system (100) according to claim 1, comprising
- a second piezo-electric plate (21) and a bendable second metal plate (22) connected to the second piezo-electric plate (21) for applying compressive forces (Fc) on the second piezo-electric plate (21) when bent and outputting electrical energy to the electrical circuit;
- a second pocket structure (23) forming a second pocket (H2) at a central part (22c) of the second metal plate (22) opposite the second piezo-electric plate (21) for allowing the bending of the second metal plate (22) at least partly into the second pocket (H2), wherein the second pocket structure (23) is configured to abut the second metal plate (22) exclusively at its outer edges (22e) with edge forces (F2) directed towards the second piezo-electric plate (21);
- wherein the pressure centralizing element (33) is disposed centrally between the piezo-electric plates (11,21), and configured to focus the central force (F1) on either side exclusively to the respective centers (11c,21c) of the piezo-electric plates (11,21) upon application of the external force (Fe) moving the force receiving surface (31) to the compressed surface position (S1);

3. The system (100) according to any of the preceding claims, comprising a resilient element (32) between the force receiving surface (31) and the first pocket structure (13) for restoring the force receiving surface (31) from the compressed surface position (S1) to the equilibrium surface position (S0) in the absence of external force (Fe).

4. The system (100) according to any of the preceding claims, comprising a resilient element (32) formed by a compressible side wall foam layer which in plane surrounds a stack of the first and/or second piezo-electric plate (11,21), the first and/or second metal plate (12,22), and the pressure centralizing element (33).

5. The system (100) according to any of the preceding claims, wherein the first and/or optional second pocket structures (13,23) comprise a respective foil with a hole centralized with respect to a position of the metal plate.

6. The system (100) according to any of the preceding claims, wherein the first and optional second piezo-electric plate (11,21) are piezoceramic plates.

7. The system (100) according to any of the preceding claims, wherein the energy harvesting system (100) comprises a rectifier circuit (41) electrically connected to electrodes of the first and/or second piezo-electric plate (11,21).

8. The system (100) according to any of the preceding claims, wherein the energy harvesting system (100) comprises one rectifier circuit (41) per pair of first and second piezo-electric plates (11,21), wherein top electrodes of the piezo-electric plates, opposite the respective metal plates are connected to each other as a first terminal connected to the rectifier circuit (41), and bottom electrodes of the piezo-electric plates at a side of the respective metal plates are connected to each other as a second terminal connected to the rectifier circuit (41) [parallel connection].

9. The system (100) according to any of the preceding claims, wherein a respective combination of a piezo-electric plate (11) and metal plate (12) is formed by a piezo-electric buzzer.

10. The system (100) according to any of the preceding claims, wherein a diameter of the first and optional second piezo-electric plate (11,21) is larger than a diameter of the pressure centralizing element (33) by at least a factor two.

11. The system (100) according to any of the preceding claims, wherein a diameter of the first and optional second metal plate (12,22) is larger than a diameter of the first and optional second pocket (H1,H2), respectively.

12. The system (100) according to any of the preceding claims, wherein a diameter of the first and optional second metal plate (12,22) is larger than a diameter of the first and optional second piezo-electric plate (11,21), respectively.

13. The system (100) according to any of the preceding claims, wherein a diameter of the first and optional second piezo-electric plate (11,12) is smaller than a diameter of the first and optional second pocket (H1,H2), respectively.

14. A floor mat comprising the system (100) according to any of the preceding claims, configured to power an electrical device when a person walks over the floor mat.

15. Use of the system (100) according to any of the preceding claims for harvesting energy (E) from a force receiving surface (31) moving under the influence of external force (Fe)
